# EUROPEAN PATENT APPLICATION

(11) **EP 4 819 492 A1**
(43) Date of publication of application: **07.10.2026**
(21) Application number: 25188616.4
(22) Date of filing: 09.07.2025
(51) Int. Cl.: H03K 17/12, H02M 1/00, H03K 17/567

(54) **HYBRID SWITCH DEVICE**

(30) Priority: 02.04.2025 CN 202510410911
(71) Applicant: DELTA ELECTRONICS, INC., Taoyuan City 320023 (TW)
(72) Inventor: CHENG, Chang-Yi, 320023 Taoyuan City (TW); LIN, Tsai-Sheng, 320023 Taoyuan City (TW); WANG, Tao, 320023 Taoyuan City (TW); TIAN, Ye, 320023 Taoyuan City (TW); CHEN, Junwen, 320023 Taoyuan City (TW)
(74) Representative: 2K Patent Partnerschaft mbB

(57) **Abstract**

A hybrid switch device (100) includes a first switch component (10), a second switch component (20), and a controller (50). The first switch component (10) is independently controlled. The second switch component (20) is connected to the first switch component (10) in parallel, and the second switch component (20) is independently controlled. The controller (50) provides a control signal (Sc) to respectively control the first switch component (10) and the second switch component (20) according to a power operating point (P) of an operating curve. Under a light load below the power operating point (P), the control signal (Sc) controls the first switch component (10) to be turned on, and under a heavy load above the power operating point (P), the control signal (Sc) controls the second switch component (20) to be turned on so as to optimize switching performance under hybrid operation of the first switch component (10) and the second switch component (20).

## Description

### BACKGROUND

### Technical Field

The present disclosure relates to a hybrid switch device, and more particularly to a hybrid switch device of combining SiC-MOSFETs and Si-IGBTs.

### Description of Related Art

The statements in this section merely provide background information related to the present disclosure and do not necessarily constitute prior art.

When using power transistor switches, usually a single switch component cannot fully apply to operations under different conditions. For example, under light load or heavy load, a single switch component has its advantages and disadvantages. Therefore, if only a single switch component is used for operation under different conditions, the optimal performance cannot be achieved.

Therefore, how to design a hybrid switch device, and more particularly to a hybrid switch device of combining SiC-MOSFETs and Si-IGBTs to solve the problems and technical bottlenecks in the existing technology has become a critical topic in this field.

### SUMMARY

An objective of the present disclosure is to provide a hybrid switch device. The hybrid switch device includes a first switch component, a second switch component, and a controller. The first switch component is independently controlled. The second switch component is connected to the first switch component in parallel and independently controlled. The controller provides a control signal to respectively control the first switch component and the second switch component according to a power operating point of an operating curve. Forward characteristics of the first switch component and the second switch component are that below the power operating point, a forward current of the first switch component is higher than a forward current of the second switch component at the same forward voltage; above the power operating point, the forward current of the first switch component is lower than the forward current of the second switch component at the same forward voltage; under a light load below the power operating point, the control signal turns on the first switch component; under a heavy load above the power operating point, the control signal turns on the second switch component so as to optimize switching performance under hybrid operation of the first switch component and the second switch component.

In one embodiment, under the light load below the power operating point, the control signal turns off the second switch component; under the heavy load above the power operating point, the control signal turns off the first switch component.

In one embodiment, under the light load below the power operating point, the operating curve is a first forward characteristic curve of the first switch component; under the heavy load above the power operating point, the operating curve is a second forward characteristic curve of the second switch component.

In one embodiment, the first switch component is a metal-oxide-semiconductor field-effect transistor (MOSFET), and the second switch component is an insulated gate bipolar transistor (IGBT).

In one embodiment, the MOSFET is a SiC-MOSFET, and the IGBT is a Si-IGBT.

In one embodiment, the SiC-MOSFET includes a first switch, a first resistor, a second resistor, and a first diode. The first resistor is connected to the first switch in series to form a first series-connected path. The first diode is connected to the second resistor in series to form a second series-connected path. The first series-connected path is connected to the second series-connected path in parallel.

In one embodiment, the Si-IGBT includes a second switch, a second diode, a third resistor, a fourth resistor, and a third diode. The second diode is connected to the second switch in series. The third resistor is connected to the second diode in series to form a third series-connected path. The third diode is connected to the fourth resistor in series to form a fourth series-connected path. The third series-connected path is connected to the fourth series-connected path in parallel.

In one embodiment, the number of the second switch components is greater than the number of the first switch components.

In one embodiment, a ratio of the number of the first switch components to the number of the second switch components is 1:3.

In one embodiment, a ratio of the number of the first switch components to the number of the second switch components is 2:2.

In one embodiment, the control signal includes a first control signal and a second control signal configured to respectively control the first switch component and the second switch component.

In one embodiment, when the number of the SiC-MOSFET and the number of the Si-IGBT are each one, a current shared by the SiC-MOSFET is a part of a total current: I_total*I_SiC_ratio; a current shared by the Si-IGBT is the other part of the total current: I_total*(1-I_SiC_ratio). I_total is the total current, and I_SiC_ratio is the ratio of the total current shared to the SiC-MOSFET.

In one embodiment, when a forward voltage of the SiC-MOSFET is less than a starting voltage of the Si-IGBT, I_SiC_ratio is 1; when the forward voltage of the SiC-MOSFET is less than a forward voltage of the Si-IGBT, I_SiC_ratio is less than 1 and greater than 0.5; when the forward voltage of the SiC-MOSFET is equal to the forward voltage of the Si-IGBT, I_SiC_ratio is equal to 0.5; when the forward voltage of the SiC-MOSFET is greater than the forward voltage of the Si-IGBT, I_SiC_ratio is less than 0.5 and greater than 0.

In one embodiment, when the number of the SiC-MOSFET is one and the number of the Si-IGBT is N, N is a positive integer greater than 1, the SiC-MOSFET is controlled to operate at an optimal power efficiency point to flow a part of the total current, and the N Si-IGBT is controlled to share the other part of the total current.

Accordingly, the present disclosure has the following features and advantages: the present disclosure combines the design strategy used by SiC-MOSFET and Si-IGBT in order to bring out the advantages of both under different operating conditions and to complement their deficiencies, thereby achieving optimal performance and efficiency of the system using the hybrid switch device.

It is to be understood that both the foregoing general description and the following detailed description are exemplary, and are intended to provide further explanation of the present disclosure as claimed. Other advantages and features of the present disclosure will be apparent from the following description, drawings, and claims.

### BRIEF DESCRIPTION OF DRAWINGS

The present disclosure can be more fully understood by reading the following detailed description of the embodiment, with reference made to the accompanying drawing as follows:
FIG. 1 is a schematic waveform diagram of forward characteristics of a first switch component and a second switch component of a hybrid switch device according to the present disclosure.
FIG. 2A is a circuit symbol diagram of the first switch component, which is a SiC-MOSFET according to the present disclosure.
FIG. 2B is an equivalent circuit diagram of the SiC-MOSFET in FIG. 2A.
FIG. 3A is a circuit symbol diagram of the second switch component, which is a Si-IGBT according to the present disclosure.
FIG. 3B is an equivalent circuit diagram of the Si-IGBT in FIG. 3A.
FIG. 4A is a circuit diagram of the hybrid switch device used in parallel according to the present disclosure.
FIG. 4B is an equivalent circuit diagram of the hybrid switch device in FIG. 4A.
FIG. 5 is a circuit diagram of the hybrid switch device according to a preferred embodiment of the present disclosure.
FIG. 6 is a waveform diagram of forward characteristics of the first switch component, the second switch component, and hybrid thereof according to the present disclosure.

### DETAILED DESCRIPTION

Reference will now be made to the drawing figures to describe the present disclosure in detail. It will be understood that the drawing figures and exemplified embodiments of present disclosure are not limited to the details thereof.

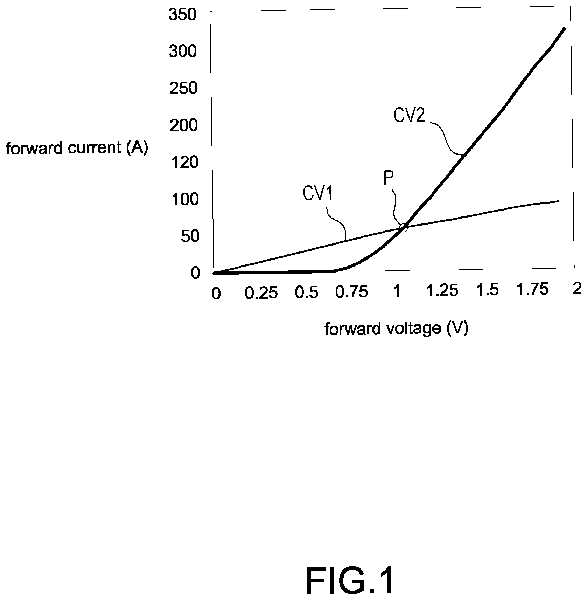

Please refer to FIG. 1, which shows a schematic waveform diagram of forward characteristics of a first switch component and a second switch component of a hybrid switch device according to the present disclosure. Specifically, the hybrid switch device includes a first switch component 10 and a second switch component 20. As shown in FIG. 1, a forward characteristic of the first switch component 10 and a forward characteristic of the second switch component 20 are shown. As seen from FIG. 1, the horizontal axis is a forward voltage of the switch component, and the vertical axis is a forward current of the switch component. Furthermore, FIG. 1 further discloses a forward characteristic curve of the first switch component 10, i.e., a first forward characteristic curve CV1, and discloses a forward characteristic curve of the second switch component 20, i.e., a second forward characteristic curve CV2.

In the above-mentioned embodiment, the first switch component 10 and the second switch component 20 may be respectively formed of, but not limited to, any power semiconductor component including an insulated gate bipolar transistor (IGBT), a silicon carbide (SiC) power component, a silicon (Si) power component and/or a gallium nitride (GaN) power component. In particular, the first switch component 10 and the second switch component 20 are power semiconductor components with different forward characteristics. Below a power operating point P, a forward current of the first switch component is higher than a forward current of the second switch component at the same forward voltage. Above the power operating point P, the forward current of the first switch component is lower than the forward current of the second switch component at the same forward voltage. Furthermore, under a light load below the power operating point P, the first switch component 10 is turned on by a control signal; under a heavy load above the power operating point P, the second switch component 20 is turned on by the control signal so as to optimize switching performance under hybrid operation of the first switch component 10 and the second switch component 20.

In the above-mentioned embodiment, the first switch component 10 and the second switch component 20 are further power semiconductor components of different types and have different forward characteristics.

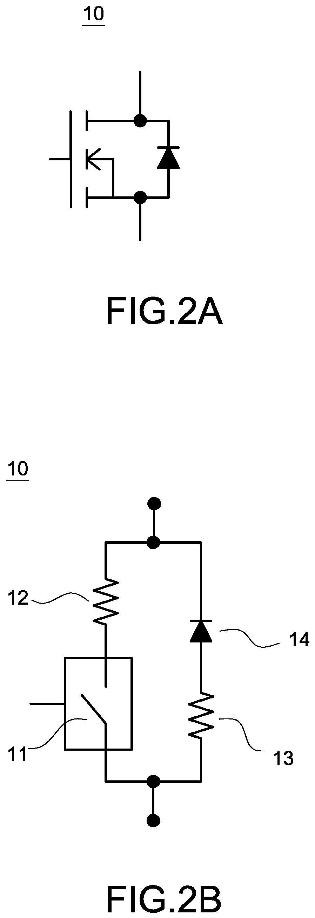

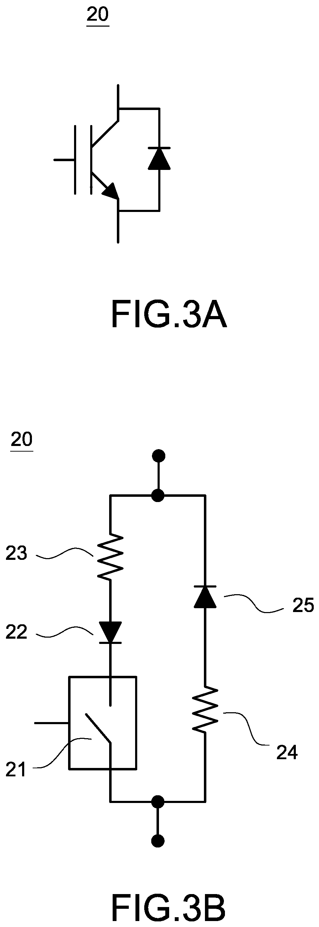

Please refer to FIG. 2A and FIG. 2B, which are a circuit symbol diagram of the first switch component, which is a SiC-MOSFET according to the present disclosure and an equivalent circuit diagram of the SiC-MOSFET in FIG. 2Arespectively. Please refer to FIG. 3A and FIG. 3B, which are a circuit symbol diagram of the second switch component, which is a Si-IGBT according to the present disclosure and an equivalent circuit diagram of the Si-IGBT in FIG. 3A respectively. In the present disclosure, the first switch component is a metal-oxide-semiconductor field-effect transistor (MOSFET), and the second switch component is an insulated gate bipolar transistor (IGBT). Specifically, the MOSFET is a SiC-MOSFET, and the IGBT is a Si-IGBT.

As shown in FIG. 2B, the first switch component 10 (i.e., the SiC-MOSFET) includes a first switch 11, a first resistor 12, a second resistor 13, and a first diode 14. The first resistor 12 is connected to the first switch 11 in series to form a first series-connected path. The first diode 14 is connected to the second resistor 13 to in series to form a second series-connected path. In particular, the first series-connected path is connected to the second series-connected path in parallel.

As shown in FIG. 3B, the second switch component 20 (i.e., the Si-IGBT) includes a second switch 21, a second diode 22, a third resistor 23, a fourth resistor 24, and a third diode 25. The second diode 22 is connected to the second switch 21 in series. The third resistor 23 is connected to the second diode 22 in series to form a third series-connected path. The third diode 25 is connected to the fourth resistor 24 in series to form a fourth series-connected path. In particular, third series-connected path is connected to the fourth series-connected path in parallel.

It may be seen from the two forward characteristic curves CV1, CV2 in FIG. 1 used to compare the forward characteristics of the first switch component 10 and the second switch component 20. For the first switch component 10 (i.e., the SiC-MOSFET), the horizontal axis is the forward voltage of the SiC-MOSFET, i.e., Vds, which is a voltage drop when the current is turned on. For the second switch component 20 (i.e., the Si-IGBT), the horizontal axis is the forward voltage of the Si-IGBT, i.e., Vce. For the first switch component 10, the vertical axis is the forward current of the SiC-MOSFET, i.e., Ids, which is the current that the switch component can conduct. For the second switch component 20, the vertical axis is the forward current of the Si-IGBT, i.e., Ice.

Furthermore, for the first switch component 10 (see the first forward characteristic curve CV1), its curve is closer to linearity, indicating that its conduction (turned-on, on-state) voltage drop is lower. Therefore, the first switch component 10 is more advantageous under conditions of high frequency and high current. For the second switch component 20 (see the second forward characteristic curve CV2), when the forward voltage is relatively low, the forward current is very small. Until the forward voltage exceeds about 1 volt, the forward current begins to rise rapidly. Therefore, the second switch component 20 has a higher conduction (turned-on, on-state) voltage drop under a conduction of high current.

Referring to FIG. 1 again, under the light load condition (i.e., low current region), the first switch component 10 (using SiC-MOSFET as an example) has the following advantages: 1. Extremely low conduction loss: since the on-resistance of SiC-MOSFET is extremely low and changes little with temperature rise, and the current is small under light load, the conduction loss ratio is lower and the efficiency is higher; 2. Ultra-fast switching speed: SiC-MOSFET has a higher switching speed since its parasitic capacitance and charge are relatively low. In light-load applications, high-frequency switching operation is usually the key. The SiC-MOSFET can significantly reduce switching losses and EMI electromagnetic interference. Moreover, the advantage of switching speed makes it suitable for high-frequency operation, greatly increasing light-load efficiency; 3. No parasitic reverse recovery current: the body diode of SiC-MOSFET has an extremely low reverse recovery current, which is almost negligible. In light-load and high-frequency applications, the loss caused by the reverse recovery of the body diode is greatly reduced.

Under the heavy load condition (i.e., high current region), the second switch component 20 (using Si-IGBT as an example) has the following advantages: 1. Strong high current handling capability: under heavy load conditions, its current capacity may reach hundreds of amperes or even higher, and can stably handle high power requirements; 2. High voltage withstand capability: it is usually designed as a high voltage withstand switch, and the high voltage withstand range is usually beneficial to the requirement of high voltage applications; 3. Good temperature stability: it has stable performance under heavy load and high temperature environment.

Therefore, the hybrid switch device of the present disclosure combines the advantages of the first switch component 10 and the second switch component 20. When the forward current is lower than the power operating point P, the first switch component 10 is used as the operated switch. When the forward current is higher than the power operating point P, the second switch component 20 is used as the operated switch.

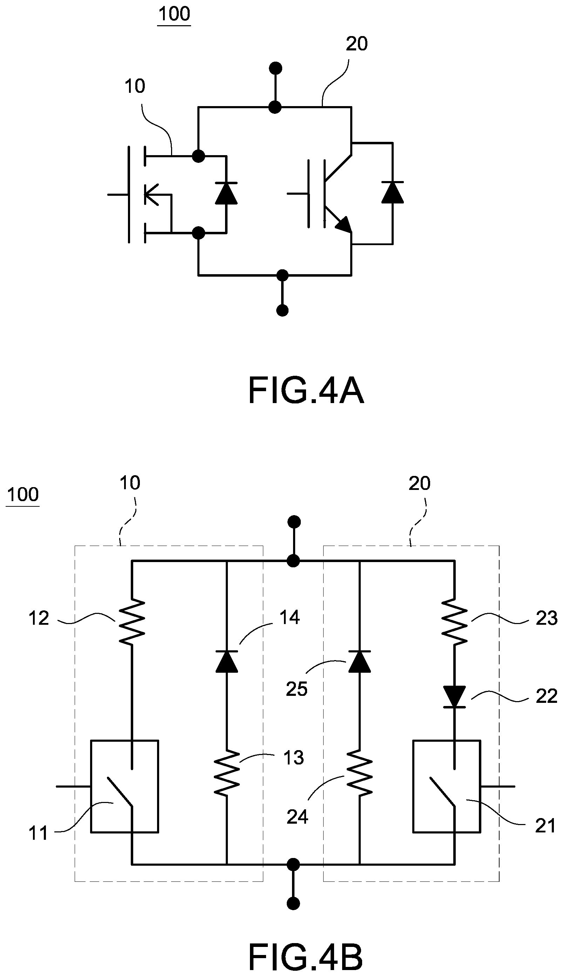

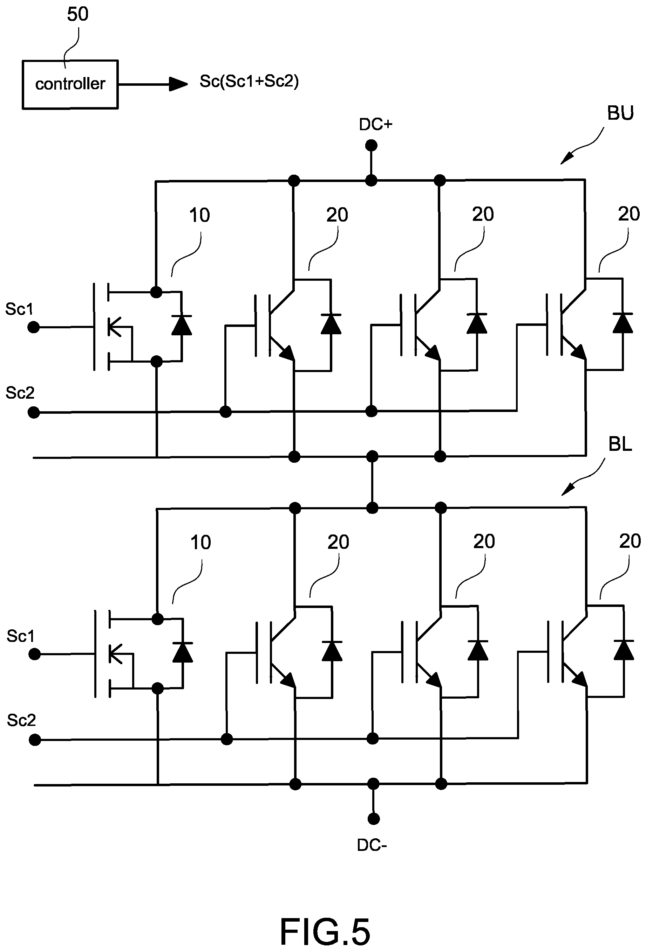

The hybrid switch device of the present disclosure uses a first switch component 10 and a second switch component 20 in a hybrid (combined) manner. Please refer to FIG. 4A and FIG. 4B, which are a circuit diagram of the hybrid switch device used in parallel according to the present disclosure and an equivalent circuit diagram of the hybrid switch device in FIG. 4A respectively. The hybrid switch device used in parallel includes a first switch component 10, a second switch component 20, and a controller 50 (see FIG. 5 for details). The first switch component 10 may be independently controlled to be turned on or off. The second switch component 20 is connected to the first switch component 10 in parallel, and the second switch component 20 may be independently controlled to be turned on or off. The controller 50 is used to generate a control signal Sc, and control the first switch component 10 and the second switch component 20 respectively according to the power operating point of the operating curve.

As mentioned above, and also refer to FIG. 1, the operating curve refers to the power operating point P as a boundary. When the forward current is lower than the power operating point P, the first forward characteristic curve CV1 is operated, that is, the control signal Sc of the controller 50 turns on the first switch component 10 and turns off the second switch component 20. On the contrary, when the forward current is higher than the power operating point P, the second forward characteristic curve CV2 is operated, that is, the control signal Sc of the controller 50 turns on the second switch component 20 and turns off the first switch component 10. In other words, under light load below the power operating point P, the control signal Sc turns on the first switch component 10 and turns off the second switch component 20. Under heavy load above the power operating point P, the control signal Sc turns on the second switch component 20 and turns off the first switch component 10. Therefore, the switching efficiency of the first switch component 10 and the second switch component 20 in hybrid operation is optimized.

Please refer to FIG. 5, which shows a circuit diagram of the hybrid switch device according to a preferred embodiment of the present disclosure. In this embodiment, the hybrid switch device 100 of the present disclosure is applied to a complete inverter bridge arm, which has an upper bridge arm BU and a lower bridge arm BL, wherein the switch structure of the upper bridge arm BU is symmetrical to the switch structure of the lower bridge arm BL. In terms of use, at least one first switch component 10 may be combined with at least one second switch component 20. Taking the preferred embodiment of FIG. 5 and the upper bridge arm BU as an example, the number of the second switch components 20 is greater than the number of the first switch components 10, that is, the number of Si-IGBTs is greater than the number of SiC-MOSFETs. Furthermore, as shown in FIG. 5, a ratio of the number of the first switch components 10 to the number of the second switch components 20 is 1:3, that is, when the number of first switch components 10 of the upper bridge arm BU is one, the number of second switch components 20 of the upper bridge arm BU is three, and so on. However, in different embodiments, the ratio of the number of the first switch components 10 to the number of the second switch components 20 is may be 2:2. Therefore, when the number of the first switch components 10 of the upper bridge arm BU is two, the number of the second switch components 20 of the upper bridge arm BU is two, and so on. Similarly, for the symmetrical switch structure of the lower bridge arm BL, when the number of the first switch components 10 of the lower bridge arm BL is two, the number of the second switch components 20 of the lower bridge arm BL is two, and so on.

According to the above-mentioned operating principle based on the power operating point of the operating curve, the first switch component 10 is controlled to be turned on under light load below the power operating point, that is, the first switch component 10 is controlled to be turned on by a first control signal Sc1 in the control signal Sc generated by the controller 50. On the contrary, the second switch component 20 is controlled to be turned on under heavy load above the power operating point, that is, the second switch component 20 is controlled to be turned on by a second control signal Sc2 in the control signal Sc generated by the controller 50. Thereby, the switching efficiency of the first switch component 10 and the second switch component 20 in hybrid operation is optimized.

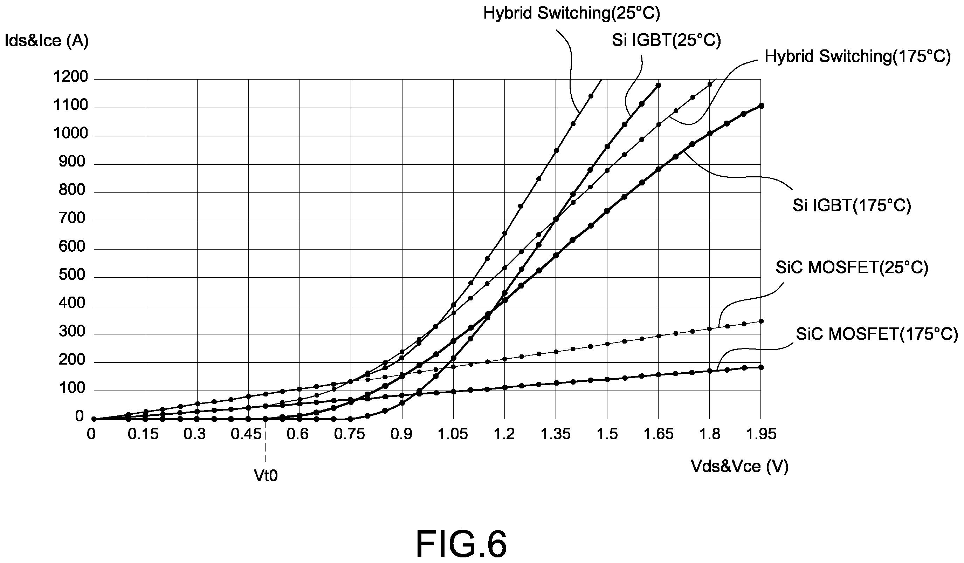

Please refer to FIG. 6, which shows a waveform diagram of forward characteristics of the first switch component, the second switch component, and hybrid thereof according to the present disclosure. FIG. 6 is intended to illustrate the current sharing strategy of SiC-MOSFET and Si-IGBT. More specifically, the current sharing ratio may be adjusted by controlling the forward voltage Vds of the SiC-MOSFET and the forward voltage Vce of the Si-IGBT so that the system can operate at the optimal power efficiency. FIG. 6 shows the performance of a single SiC-MOSFET at 25°C and 175°C, a single Si-IGBT at 25°C and 175°C, and the hybrid of both at 25°C and 175°C.

First, a hybrid switch device of a single SiC-MOSFET and a single Si-IGBT is taken as an example for explanation. It is assumed that a total current is I_total, and a ratio of the current flowing through the SiC-MOSFET to the total current I_total is I_SiC_ratio, and therefore a ratio of the current flowing through the Si-IGBT to the total current I_total is (1-I_SiC ratio). In particular, the current distribution ratio I_SiC_ratio is adjusted according to the forward voltage Vds and the forward voltage Vce. In one embodiment of the present disclosure, when Vds<Vt0, I_SiC_ratio=1, that is, all current flows to SiC-MOSFET. In other words, the current flowing to SiC-MOSFET is I_total, and the current flowing to Si-IGBT is 0. In particular, Vt0 as shown in FIG. 6 is a starting voltage of the Si-IGBT.

When Vds<Vce and 1>I_SiC_ratio>0.5, the current flowing through the SiC-MOSFET is greater than the current flowing through the Si-IGBT. When Vds=Vce and I_SiC_ratio=0.5, the current flowing through the SiC-MOSFET is equal to the current flowing through the Si-IGBT, that is, the SiC-MOSFET and Si-IGBT evenly share the total current I_total. When Vds>Vce and 0.5>I_SiC_ratio>0, the current flowing through the Si-IGBT is greater than the current flowing through the SiC-MOSFET.

Therefore, the current distribution ratio of SiC-MOSFET and Si-IGBT is controlled according to the Vgs of SiC-MOSFET and the Vt0 at the temperature of Si-IGBT or the relative size of the forward voltages Vce and Vgs, and then the optimal efficiency is achieved by controlling the current distribution ratio of SiC-MOSFET and Si-IGBT.

In particular, the temperatures shown in FIG. 6 refer to the operating temperature of the chip, for example, the forward characteristics of a single Si-IGBT, a single SiC-MOSFET, and a hybrid switch component at an operating temperature of 25°C, or the forward characteristics of a single Si-IGBT, a single SiC-MOSFET, and a hybrid switch component at an operating temperature of 175°C. Incidentally, due to the different characteristics of SiC-MOSFET and Si-IGBT, the temperature of hybrid operation of the two switch components is not necessarily the same, but information on hybrid drive can be found based on the forward characteristics at a specific temperature.

Furthermore, the starting voltage Vt0 of Si-IGBT at different temperatures is also different. Furthermore, the power operating point P (see FIG. 1), i.e., the position where the forward voltage Vds is equal to the forward voltage Vce is also different.

In addition, the single characteristic and the hybrid driving characteristic of the above-mentioned switch component can satisfy the application of DC to AC conversion, and can also satisfy the application of AC to DC conversion. Furthermore, although FIG. 6 shows the forward characteristics of the first switch component and the second switch component and the forward characteristics under hybrid driving, the principles of the reverse characteristics of the first switch component and the second switch component and the reverse characteristics under hybrid driving are also applicable.

Furthermore, when the ratio of the number of SiC-MOSFET to Si-IGBT is 1:N, where N is a positive integer greater than 1, the SiC-MOSFET may be controlled to flow through the total current at the optimal power efficiency point first (priority), and the remaining current is shared by the Si-IGBT, that is, when there are multiple Si-IGBTs, the remaining current is shared by the multiple Si-IGBTs. Similarly, when multiple Si-IGBTs are operated in parallel, the current distribution ratio is adjusted according to the temperature conditions of each Si-IGBT to maintain the optimal power efficiency after the hybrid (combination).

In summary, the present disclosure has the following features and advantages: the present disclosure combines the design strategy used by SiC-MOSFET and Si-IGBT in order to bring out the advantages of both under different operating conditions and to complement their deficiencies, thereby achieving optimal performance and efficiency of the system using the hybrid switch device.

## Claims

1. A hybrid switch device (100), **characterized in that** the hybrid switch device (100) comprising:
a first switch component (10) independently controlled,
a second switch component (20) connected to the first switch component (10) in parallel and independently controlled, and
a controller (50) configured to provide a control signal (Sc) to respectively control the first switch component (10) and the second switch component (20) according to a power operating point (P) of an operating curve,
wherein forward characteristics of the first switch component (10) and the second switch component (20) are that below the power operating point (P), a forward current of the first switch component (10) is higher than a forward current of the second switch component (20) at the same forward voltage; above the power operating point (P), the forward current of the first switch component (10) is lower than the forward current of the second switch component (20) at the same forward voltage; under a light load below the power operating point (P), the control signal (Sc) is configured to turn on the first switch component (10); under a heavy load above the power operating point (P), the control signal (Sc) is configured to turn on the second switch component (20) so as to optimize switching performance under hybrid operation of the first switch component (10) and the second switch component (20).

2. The hybrid switch device (100) as claimed in claim 1, wherein under the light load below the power operating point (P), the control signal (Sc) is configured to turn off the second switch component (20); under the heavy load above the power operating point (P), the control signal (Sc) is configured to turn off the first switch component (10).

3. The hybrid switch device (100) as claimed in claim 1, wherein under the light load below the power operating point (P), the operating curve is a first forward characteristic curve (CV1) of the first switch component (10); under the heavy load above the power operating point (P), the operating curve is a second forward characteristic curve (CV2) of the second switch component (20).

4. The hybrid switch device (100) as claimed in claim 1, wherein the first switch component (10) is a metal-oxide-semiconductor field-effect transistor (MOSFET), and the second switch component (20) is an insulated gate bipolar transistor (IGBT).

5. The hybrid switch device (100) as claimed in claim 4, wherein the MOSFET is a SiC-MOSFET, and the IGBT is a Si-IGBT.

6. The hybrid switch device (100) as claimed in claim 5, wherein the SiC-MOSFET comprises:
a first switch (11),
a first resistor (12) connected to the first switch (11) in series to form a first series-connected path,
a second resistor (13), and
a first diode (14) connected to the second resistor (13) in series to form a second series-connected path,
wherein the first series-connected path is connected to the second series-connected path in parallel.

7. The hybrid switch device (100) as claimed in claim 5, wherein the Si-IGBT comprises:
a second switch (21),
a second diode (22) connected to the second switch (21) in series,
a third resistor (23) connected to the second diode (22) in series to form a third series-connected path,
a fourth resistor (24), and
a third diode (25) connected to the fourth resistor (24) in series to form a fourth series-connected path,
wherein the third series-connected path is connected to the fourth series-connected path in parallel.

8. The hybrid switch device (100) as claimed in claim 1, wherein the number of the second switch components (20) is greater than the number of the first switch components (10).

9. The hybrid switch device (100) as claimed in claim 8, wherein a ratio of the number of the first switch components (10) to the number of the second switch components (20) is 1:3.

10. The hybrid switch device (100) as claimed in claim 8, wherein a ratio of the number of the first switch components (10) to the number of the second switch components (20) is 2:2.

11. The hybrid switch device (100) as claimed in claim 1, wherein the control signal (Sc) comprises a first control signal (Sc1) and a second control signal (Sc2) configured to respectively control the first switch component (10) and the second switch component (20).

12. The hybrid switch device (100) as claimed in claim 5, wherein when the number of the SiC-MOSFET and the number of the Si-IGBT are each one, a current shared by the SiC-MOSFET is a part of a total current: I_total*I_SiC_ratio; a current shared by the Si-IGBT is the other part of the total current: I_total*(1-I_SiC_ratio);
wherein I_total is the total current, and I_SiC_ratio is the ratio of the total current shared to the SiC-MOSFET.

13. The hybrid switch device (100) as claimed in claim 12, wherein when a forward voltage of the SiC-MOSFET is less than a starting voltage of the Si-IGBT, I_SiC_ratio is 1; when the forward voltage of the SiC-MOSFET is less than a forward voltage of the Si-IGBT, I_SiC_ratio is less than 1 and greater than 0.5; when the forward voltage of the SiC-MOSFET is equal to the forward voltage of the Si-IGBT, I_SiC_ratio is equal to 0.5; when the forward voltage of the SiC-MOSFET is greater than the forward voltage of the Si-IGBT, I_SiC_ratio is less than 0.5 and greater than 0.

14. The hybrid switch device (100) as claimed in claim 5, wherein when the number of the SiC-MOSFET is one and the number of the Si-IGBT is N, N is a positive integer greater than 1, the SiC-MOSFET is controlled to operate at an optimal power efficiency point to flow a part of the total current, and the N Si-IGBT is controlled to share the other part of the total current.

## Amended claims

### Amended claims in accordance with Rule 137(2) EPC.

1. A hybrid switch device (100), **characterized in that** the hybrid switch device (100) comprising:
a first switch component (10) comprising a SiC-MOSFET, and independently controlled,
a second switch component (20) comprising a plurality of Si-IGBTs connected to the first switch component (10) in parallel and independently controlled, wherein a quantity ratio of the SiC-MOSFET to the plurality of Si-IGBTs is 1: N, and N is a positive integer greater than 1, and
a controller (50) configured to provide a control signal (Sc) to respectively control the first switch component (10) and the second switch component (20) according to a power operating point (P) of an operating curve,
wherein forward characteristics of the first switch component (10) and the second switch component (20) are that below the power operating point (P), a forward current of the first switch component (10) is higher than a forward current of the second switch component (20) at the same forward voltage; above the power operating point (P), the forward current of the first switch component (10) is lower than the forward current of the second switch component (20) at the same forward voltage; under a light load below the power operating point (P), the control signal (Sc) is configured to turn on the first switch component (10); under a heavy load above the power operating point (P), the control signal (Sc) is configured to turn on the second switch component (20) so as to optimize switching performance under hybrid operation of the first switch component (10) and the second switch component (20);
**characterized in that** the controller (50) is further configured to:
prioritize the first switch component (10) to flow through a total current below the power operating point (P); and
dynamically adjust a current distribution ratio among the plurality of Si-IGBTs according to individual temperature conditions of each Si-IGBT to maintain optimal power efficiency, wherein the controller (50) accounts for a shift of the power operating point (P) and a starting voltage (Vt0) of the Si-IGBTs caused by temperature variations.

2. The hybrid switch device (100) as claimed in claim 1, wherein under the light load below the power operating point (P), the control signal (Sc) is configured to turn off the second switch component (20); under the heavy load above the power operating point (P), the control signal (Sc) is configured to turn off the first switch component (10).

3. The hybrid switch device (100) as claimed in claim 1, wherein under the light load below the power operating point (P), the operating curve is a first forward characteristic curve (CV1) of the first switch component (10); under the heavy load above the power operating point (P), the operating curve is a second forward characteristic curve (CV2) of the second switch component (20).

4. The hybrid switch device (100) as claimed in claim 1, wherein the SiC-MOSFET comprises:
a first switch (11),
a first resistor (12) connected to the first switch (11) in series to form a first series-connected path,
a second resistor (13), and
a first diode (14) connected to the second resistor (13) in series to form a second series-connected path,
wherein the first series-connected path is connected to the second series-connected path in parallel.

5. The hybrid switch device (100) as claimed in claim 1, wherein the Si-IGBT comprises:
a second switch (21),
a second diode (22) connected to the second switch (21) in series,
a third resistor (23) connected to the second diode (22) in series to form a third series-connected path,
a fourth resistor (24), and
a third diode (25) connected to the fourth resistor (24) in series to form a fourth series-connected path,
wherein the third series-connected path is connected to the fourth series-connected path in parallel.

6. The hybrid switch device (100) as claimed in claim 1, wherein the number of the second switch components (20) is greater than the number of the first switch components (10).

7. The hybrid switch device (100) as claimed in claim 6, wherein a ratio of the number of the first switch components (10) to the number of the second switch components (20) is 1:3.

8. The hybrid switch device (100) as claimed in claim 6, wherein a ratio of the number of the first switch components (10) to the number of the second switch components (20) is 2:2.

9. The hybrid switch device (100) as claimed in claim 1, wherein the control signal (Sc) comprises a first control signal (Sc1) and a second control signal (Sc2) configured to respectively control the first switch component (10) and the second switch component (20).

10. The hybrid switch device (100) as claimed in claim 1, wherein when the number of the SiC-MOSFET and the number of the Si-IGBT are each one, a current shared by the SiC-MOSFET is a part of the total current: I_total*I_SiC ratio; a current shared by the Si-IGBT is the other part of the total current: I_total*(1-I_SiC_ratio);
wherein I_total is the total current, and I_SiC_ratio is the ratio of the total current shared to the SiC-MOSFET.

11. The hybrid switch device (100) as claimed in claim 10, wherein when a forward voltage of the SiC-MOSFET is less than a starting voltage of the Si-IGBT, I_SiC_ratio is 1; when the forward voltage of the SiC-MOSFET is less than a forward voltage of the Si-IGBT, I_SiC_ratio is less than 1 and greater than 0.5; when the forward voltage of the SiC-MOSFET is equal to the forward voltage of the Si-IGBT, I_SiC_ratio is equal to 0.5; when the forward voltage of the SiC-MOSFET is greater than the forward voltage of the Si-IGBT, I_SiC ratio is less than 0.5 and greater than 0.

12. The hybrid switch device (100) as claimed in claim 1, wherein the SiC-MOSFET is controlled to operate at an optimal power efficiency point to flow a part of the total current, and the N Si-IGBT is controlled to share the other part of the total current.
